# EUROPEAN PATENT SPECIFICATION

(11) **EP 2 958 413 B1**
(45) Date of publication and mention of the grant of the patent: **28.03.2018**
(21) Application number: 13875052.6
(22) Date of filing: 18.02.2013
(51) Int. Cl.: H05K 13/04, H05K 13/02, H05K 13/08

(54) **ELECTRONIC CIRCUIT COMPONENT MOUNTING DEVICE**
MONTAGESYSTEM FÜR KOMPONENTEN ELEKTRONISCHER SCHALTUNGEN
DISPOSITIF DE MONTAGE DE COMPOSANTS DE CIRCUIT ÉLECTRONIQUE

(43) Date of publication of application: 23.12.2015
(73) Proprietor: Fuji Machine Mfg. Co., Ltd., Chiryu-shi Aichi 472-8686 (JP)
(72) Inventor: NOZAWA, Mizuho, Chiryu-shi Aichi 472-8686 (JP)
(74) Representative: Grünecker Patent- und Rechtsanwälte PartG mbB
(86) International application number: PCT/JP2013/053884
(87) International publication number: WO 2014/125648

(56) References cited:
- EP-A2- 0 805 620
- EP-A2- 0 845 934
- JP-A- H10 163 677
- JP-A- 2008 270 332
- JP-A- 2008 270 332
- JP-A- 2011 009 710
- US-A- 5 852 869
- US-B1- 6 210 081

## Description

### Technical Field

The present invention relates to an electronic circuit component mounting device, and more particularly, to an electronic circuit component mounting device in which a bulk feeder is moved together with a mounting device.

### Background Art

This kind of electronic circuit component mounting device is disclosed in the following PTL 1. In this electronic circuit component mounting device, a moving member, which is moved in an X-axis direction and a Y-axis direction, is provided with a plurality of mounting devices and each of the mounting devices is provided with a bulk feeder. While being moved, each mounting device takes an electronic circuit component out of a corresponding bulk feeder and mounts the electronic circuit component on a board. Further examples of electronic circuit component mounting devices are disclosed in PTL 2 to PTL 6.

### Citation List

### Patent Literature

PTL 1: JP-A-2002-280793
PTL 2: US 5 852 869 A
PTL 3: EP 0 805 620 A2
PTL 4: EP 0 845 934 A2
PTL 5: JP 2008 270332 A
PTL 6: US 6 210 081 B1

### Summary of Invention

### Technical Problem

The present invention has been made in consideration of the above-mentioned circumstances, and an object of the invention is to improve the practicality of an electronic circuit component mounting device in which a bulk feeder is moved together with a mounting device.

### Solution to Problem

The above-mentioned object is achieved by an electronic circuit component mounting device according to the terms of claim 1, inter alia including: (I) a circuit substrate holding device that detachably holds a circuit substrate; (II) a bulk feeder that includes (a) a component storage portion storing electronic circuit components in bulk and (b) a component feed portion aligning the electronic circuit components, which are stored in the component storage portion, in a guide passage in a line and feeding the electronic circuit components to a component supply section; (III) a mounting device that includes (a) a suction nozzle sucking and holding the electronic circuit component by negative pressure, (b) a suction-negative pressure control valve controlling the supply of component suction-negative pressure to the suction nozzle, and (c) a nozzle lifting and lowering device lifting and lowering the suction nozzle, and takes the electronic circuit components out of the component supply section of the bulk feeder one by one by the suction nozzle and mounts the electronic circuit component on the circuit substrate held by the circuit substrate holding device; (IV) a head body that is provided so as to be movable relative to the circuit substrate holding device and forms a mounting head together with the bulk feeder and the mounting device; (V) a head moving device that moves the mounting head relative to the circuit substrate holding device by moving the head body; (i) one actuator; and (ii) a mechanical synchronization device that mechanically synchronizes (A) the lowering of the suction nozzle with (B) at least one of (a) at least a part of operations for supplying the components by the bulk feeder and (b) the start of supplying of component suction-negative pressure, which is performed by the suction-negative pressure control valve, by mechanically transmitting the motion of the actuator to the nozzle lifting and lowering device and at least one of the bulk feeder and the suction-negative pressure control valve.

Examples of the circuit substrate include (a) a printed wiring board on which an electronic circuit component is not yet mounted, (b) a printed circuit board where an electronic circuit component is mounted on and electrically connected to one surface and an electronic circuit component is not mounted on the other surface, (c) a substrate on which a bare chip is mounted and which forms a board with a chip, (d) a substrate on which an electronic circuit component including a ball grid array is mounted, and (e) a substrate that does not have the shape of a flat plate and has a three-dimensional shape.

Examples of the actuator include an electric motor and a hydraulic cylinder. The electric motor includes an electric rotating motor and a linear motor, and the hydraulic cylinder includes a pneumatic cylinder and an oil pressure cylinder.

### Advantageous Effects of Invention

Since a plurality of operations are performed in synchronization with each other on the basis of the motion of one actuator, time required to take an electronic circuit component out of a bulk feeder by a suction nozzle is shorter than that in a case in which a plurality of operations are performed without being synchronized. For this reason, since the bulk feeder is moved together with the mounting device and supplies electronic circuit components in the electronic circuit component mounting device according to the invention, time required to take an electronic circuit component out of the component supply device by the suction nozzle is short and time required to take a component out is further reduced by the synchronization of a plurality of operations. As a result, practicality is improved. Moreover, since synchronization is mechanically performed, accuracy is improved and the number of power supply lines and signal lines is small in comparison with a case in which a plurality of devices including driving sources are electrically controlled for the synchronization of a plurality of operations. Accordingly, the apparatus can be formed at a low cost.

### Brief Description of Drawings

[Fig. 1] Fig. 1 is a perspective view of a part of an electronic circuit component mounting line including a plurality of mounting modules each of which is an electronic circuit component mounting device according to an embodiment of the invention.
[Fig. 2] Fig. 2 is a perspective view of a mounting head and a head moving device of the mounting module.
[Fig. 3] Fig. 3 is a perspective view of the mounting head.
[Fig. 4] Fig. 4 is a perspective view of a portion of the mounting head in the vicinity of a component mounting position.
[Fig. 5] Fig. 5 is a perspective view of a portion of the mounting head in the vicinity of a component take-out position.
[Fig. 6] Fig. 6 is a side view of a component case and a base of a bulk feeder provided at the component take-out position.
[Fig. 7] Fig. 7 is a side view of the bulk feeder and a mounting device for a component case with a passage.
[Fig. 8] Fig. 8 is a plan view of a portion of the bulk feeder in the vicinity of a component supply section.
[Fig. 9] Fig. 9 is a plan view (partial section) of a negative pressure supply passage and a component feeding-negative pressure control valve that are provided in the base of the bulk feeder.
[Fig. 10] Fig. 10 is a plan view of a shutter that is provided in the base.
[Fig. 11] Fig. 11 is a front view showing the section of a portion of the base in the vicinity of the component supply section.
[Fig. 12] Fig. 12 is a front view (partial section) of a nozzle lifting and lowering device, a second lifting and lowering member, and the like that are provided at the component take-out position.
[Fig. 13] Fig. 13 is a perspective view of the second lifting and lowering member that is taken out.
[Fig. 14] Fig. 14 is a block diagram conceptually showing a control device and the like of the mounting module.
[Fig. 15] Fig. 15 is a cycle diagram illustrating the lifting and lowering of a suction nozzle, the switching of a control valve device, the opening and closing of the shutter, and the control of the component feeding-negative pressure control valve when a component is taken out of the bulk feeder.
[Fig. 16] Fig. 16 is a plan view showing a state in which the shutter is positioned at an opening position and the component feeding-negative pressure control valve is switched to a component feeding-negative pressure blocking state.
[Fig. 17] Fig. 17 is a view illustrating the movement and the like of the shutter to the opening position.

### Description of Embodiments

An embodiment of the invention will be described below with reference to the drawings. Meanwhile, the invention can be embodied in the form of various modifications other than the following embodiment on the basis of the knowledge of those skilled in the art.

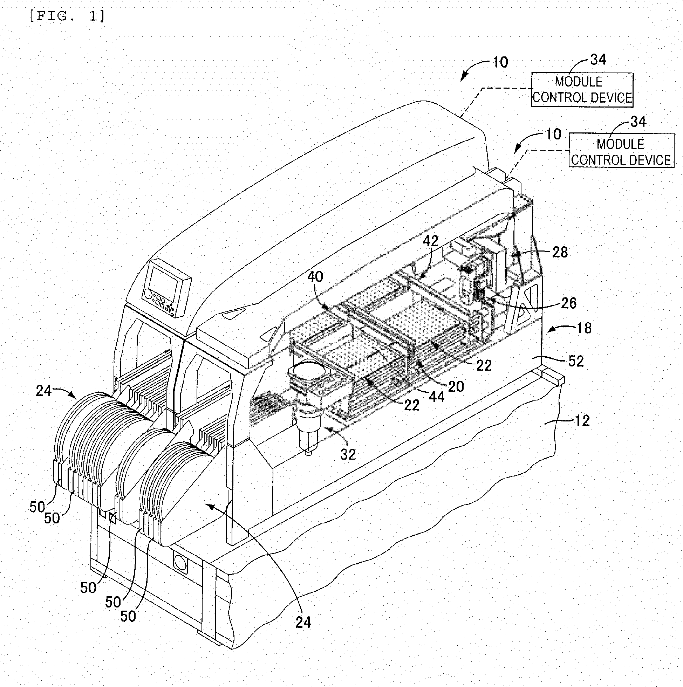

Fig. 1 shows a plurality of mounting modules 10 each of which is an electronic circuit component mounting device according to an embodiment of the invention. These mounting modules 10 are arranged in a line on a common and integrated base 12 so as to be adjacent to each other, are fixed to the base 12, and form a mounting line. Since the mounting module 10 is described in detail in, for example, JP-A-2004-104075, portions other than portions of the mounting module 10 related to the invention will be briefly described. Meanwhile, an electronic circuit component will be abbreviated as a component in the following description.

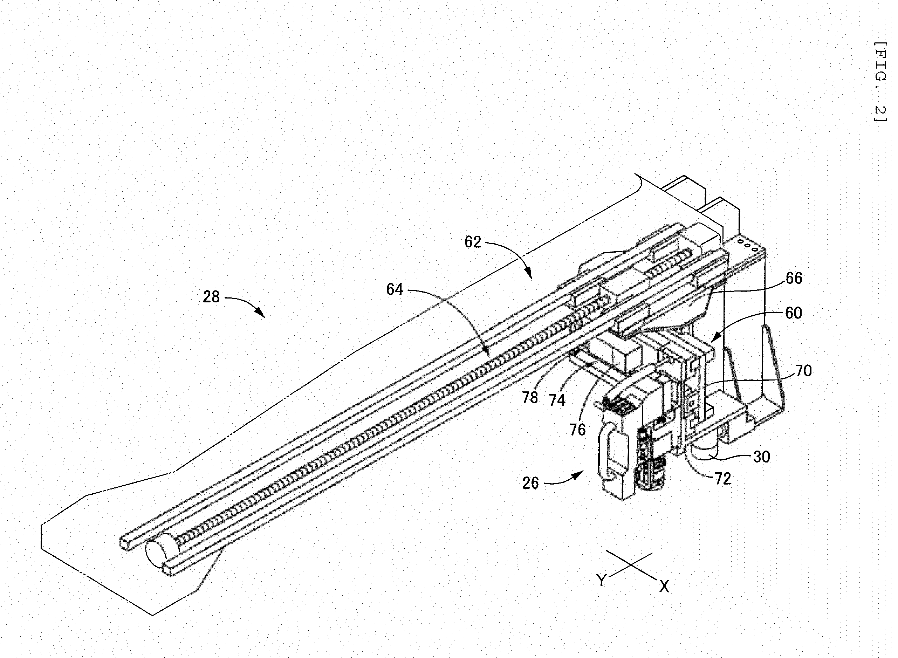

In this embodiment, each mounting module 10 includes a module body 18 that is a body of a component mounting device, a circuit board conveyance device 20 that is a circuit substrate conveyance device, circuit board holding devices 22 that are circuit substrate holding devices, a component supply device 24, a mounting head 26, a head moving device 28, a fiducial mark imaging device 30 (see Fig. 2), a component imaging device 32, and a module control device 34.

In this embodiment, the circuit board conveyance device 20 includes two board conveyors 40 and 42, and conveys a circuit board 44 (hereinafter, abbreviated as a board 44), which is one kind of a circuit substrate, in a horizontal direction that is parallel to a direction in which the plurality of mounting modules 10 are arranged. In this embodiment, the "circuit board" is a generic term for a printed wiring board and a printed circuit board. The circuit board holding devices 22 are provided on the module body 18 so as to correspond to the two board conveyors 40 and 42, respectively. Each circuit board holding device 22 includes a support member that supports the board 44 from below and clamping members that clamp both side edge portions of the board 44 parallel to the conveying direction of the board 44, respectively, although not shown. Accordingly, each circuit board holding device 22 detachably holds the board 44 so that a component mounting surface of the board on which components are mounted is horizontal. In this embodiment, the conveying direction of the board 44 conveyed by the circuit board conveyance device 20 is defined as an X-axis direction and a direction, which is present in a plane parallel to the component mounting surface of the board 44 held by the circuit board holding device 22 and is orthogonal to the X-axis direction in a horizontal plane, is defined as a Y-axis direction. In this embodiment, the component supply device 24 is to supply components by a plurality of tape feeders 50 that are alignment component feeders, and is detachably mounted on a component supply stage (not illustrated) provided on a base 52 of the module body 18 so that the position of the component supply device 24 is fixed.

As shown in Fig. 2, the head moving device 28 includes an X-axis-direction moving device 60 and a Y-axis-direction moving device 62. The Y-axis-direction moving device 62 includes a linear motor 64 that is provided on the module body 18 across a component supply section of the component supply device 24 and the two circuit board holding devices 22, and moves a Y-axis slide 66 as a moving member, which is a movable member, to an arbitrary position in the Y-axis direction. The X-axis-direction moving device 60 includes: two X-axis slides 70 and 72 as moving members that are movable members provided on the Y-axis slide 66, moved relative to the Y-axis slide 66 in the X-axis direction, and moved relative to each other in the X-axis direction; and X-axis slide moving devices 74 that move the slides 70 and 72 in the X-axis direction, respectively (an X-axis slide moving device moving the X-axis slide 72 is shown in Fig. 2).

For example, each of the two X-axis slide moving devices includes an electric motor 76 that is a driving source and a feed screw mechanism 78 that includes a screw shaft and a nut. As in the case of the X-axis slide moving device 74, the two X-axis slide moving devices move the X-axis slides 70 and 72 to arbitrary positions in the X-axis direction. Accordingly, the X-axis slide 72 is moved to an arbitrary position in a horizontal movement plane. In this embodiment, the electric motor 76 is formed of a servo motor with an encoder. A servo motor is an electric rotating motor in which a rotation angle can be accurately controlled, and a stepping motor or a linear motor may be used instead of a servo motor. Further, a ball screw mechanism is suitable as the feed screw mechanism. The same is also applied to another electric motor and another feed screw mechanism to be described below. The head moving device may have a structure in which the Y-axis-direction moving device is provided on the X-axis slide. The mounting head 26 is detachably mounted on the X-axis slide 72, is moved relative to the circuit board holding device 22 with the movement of the X-axis slide 72, and is moved to an arbitrary position in a head movement region that is a movement region provided across the component supply section of the component supply device 24 and the two circuit board holding devices 22.

The fiducial mark imaging device 30 is mounted on the X-axis slide 72 as shown in Fig. 2, is moved together with the mounting head 26 by the head moving device 28, and images a fiducial mark (not illustrated) provided on the board 44. Further, the component imaging device 32 is provided so that the position of the component imaging device 32 is fixed at a portion of the base 52 between the circuit board conveyance device 20 and the component supply device 24 as shown in Fig. 1, and images a component, which is an object to be imaged, from below.

The mounting head 26 will be described. Since the mounting head 26 is described in detail in the specification of Japanese Patent Application No. 2011-206452 and the specification of PCT/JP2012/074105 that are related to the application of the applicant although not yet published, portions other than portions of the mounting head 26 related to the invention will be briefly described.

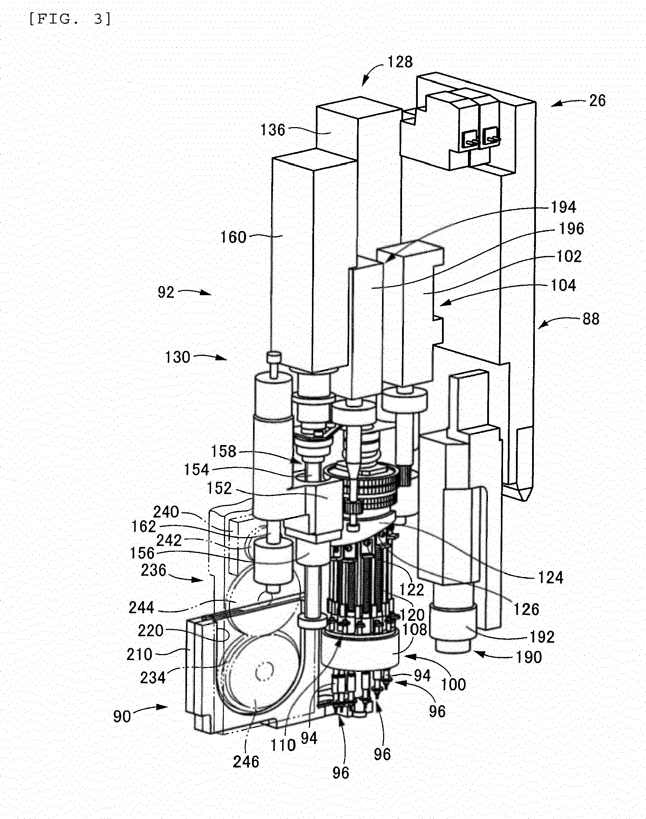

As shown in Fig. 3, the mounting head 26 includes a head body 88, a bulk feeder 90, and a mounting device 92. The mounting device 92 is to hold a component by a suction nozzle, and includes at least one nozzle holder 94, for example, a plurality of (three or more in this embodiment) nozzle holders 94, specifically, twelve nozzle holders 94 in an example shown in Fig. 3. Twelve suction nozzles 96 can be held at the maximum.

A rotating body 100 is supported by the head body 88 so as to be rotatable about a vertical axis thereof, and is rotated by an arbitrary angle about the vertical axis in both normal and reverse directions with a rotational driving device 104 that uses an electric motor 102 as a driving source. The twelve nozzle holders 94 are fitted into a nozzle holding portion 108 at twelve positions that are spaced on the circumference, which has a center on the axis of rotation of the rotating body 100, of the outer peripheral portion of the nozzle holding portion 108 of the rotating body 100 at appropriate intervals (that is, in this embodiment, at twelve positions spaced at regular angular intervals) so that the axial directions of the twelve nozzle holders 94 are parallel to the axis of rotation of the rotating body 100 and the twelve nozzle holders 94 are relatively movable in the axial directions and rotatable about the axes thereof. The twelve nozzle holders 94 hold suction nozzles 96.

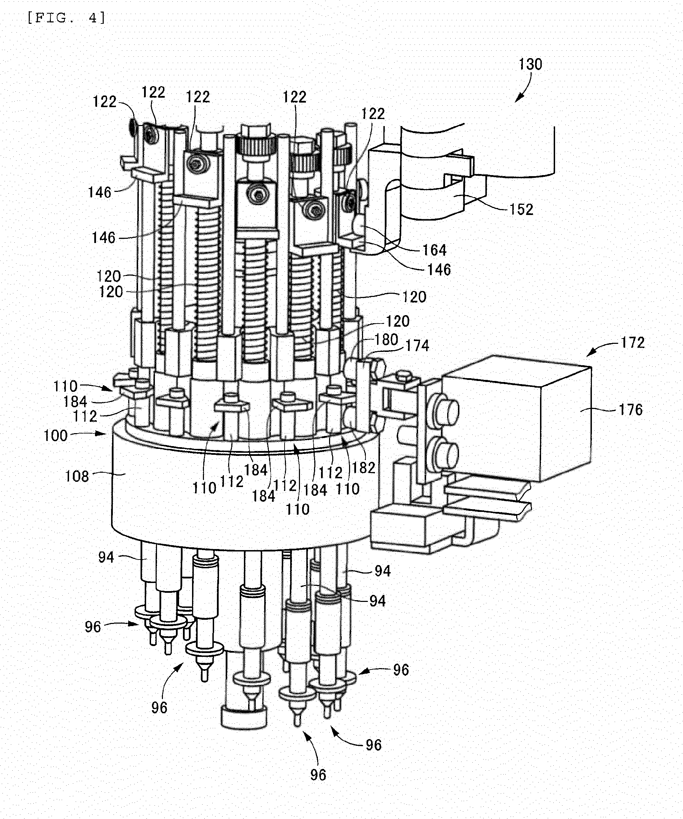

As shown in Fig. 4, control valve devices 110 are provided at the rotating body 100 so as to correspond to the twelve nozzle holders 94, respectively. Each of the control valve devices 110 is formed of a spool valve in this embodiment, and includes a valve spool 112 that is fitted into the nozzle holding portion 108 so as to be movable in a direction parallel to the axis of rotation of the rotating body 100. The control valve devices 110 are connected to a negative pressure source and a positive pressure source (not shown) through negative pressure supply passages, positive pressure supply passages (not shown), and the like that are provided in the rotating body 100 and the head body 88. Further, the control valve devices 110 communicate with the suction nozzles 96 through passages (not illustrated) provided in the nozzle holding portion 108 and passages (not illustrated) provided in the nozzle holders 94. In this embodiment, when the valve spool 112 is lowered relative to the nozzle holding portion 108, the control valve device 110 is switched to a negative pressure supply state in which component suction-negative pressure is supplied from a positive pressure supply state in which positive pressure is supplied to the suction nozzle 96. When the valve spool 112 is lifted, the control valve device 110 is switched to the positive pressure supply state from the negative pressure supply state. The control valve device 110 forms a suction-negative pressure control valve.

When the rotating body 100 is intermittently rotated by the same angle as an angular interval of the nozzle holders 94, the twelve suction nozzles 96 are sequentially stopped at twelve stop positions. Furthermore, as shown in Fig. 3, each nozzle holder 94 is biased upward by a compression coil spring 120 and a roller 122, which is a cam follower provided above the compression coil spring 120, is moved along a cam surface 126 of a cam 124 fixed to the head body 88. Accordingly, the suction nozzles 96 are lifted and lowered while revolving around the axis of rotation of the rotating body 100.

For this reason, a distance between the suction nozzle 96 and the circuit board holding device 22 in a height direction at the twelve stop positions is not constant; the stop position at which the distance therebetween is shortest is a component mounting position at which a component is mounted on the board 44; the stop position, at which the distance is longest and the height of the suction nozzle 96 is greatest and which is spaced from the component mounting position by an angle of 180°, is a component imaging position; and the stop position between the component mounting position and the component imaging position is a component take-out position at which the suction nozzle 96 takes out a component from the bulk feeder 90. Since all of the taking of a component out of the tape feeder 50 by the suction nozzle 96 and the mounting of the components, which are taken out of the tape feeder 50 and the bulk feeder 90, on the board 44 are performed at the component mounting position, the component mounting position is also a component take-out/mounting position. Meanwhile, the compression coil spring 120 is a type of a spring as an elastic member that is a type of a biasing device. The same is also applied to another coil spring to be described below.

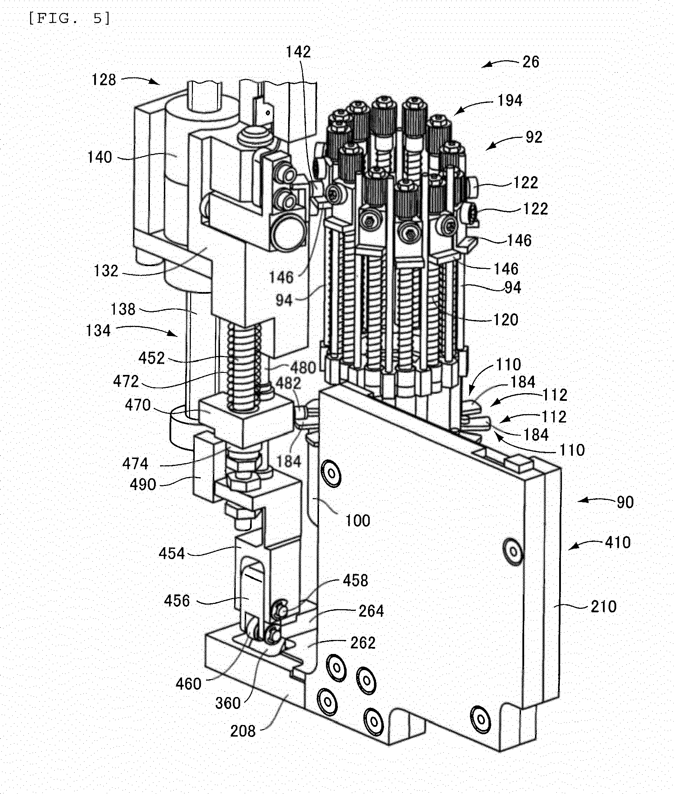

A nozzle lifting and lowering device 128 is provided at a portion of the head body 88 corresponding to the component take-out position as shown in Fig. 5, and a nozzle lifting and lowering device 130 is provided at a portion corresponding to the component mounting position as shown in Fig. 3. The nozzle lifting and lowering device 128 includes a lifting and lowering member 132 that is a first lifting and lowering member (hereinafter, referred to as a first lifting and lowering member 132), a feed screw mechanism 134, and an electric motor 136 (see Fig. 3) as shown in Fig. 5 in this embodiment. The feed screw mechanism 134 includes a feed screw 138 and a nut 140. The first lifting and lowering member 132 is fixed to the nut 140, and a roller 142 as a rotary engaging member is mounted on the rotating body 100 so as to be rotatable about an axis orthogonal to the axis of rotation of the rotating body 100 and forms an engaging portion. When the feed screw 138 is rotated by the electric motor 136, the first lifting and lowering member 132 is moved to an arbitrary position in a vertical direction while being guided by a guide rod (not illustrated) which forms a guide device.

As the first lifting and lowering member 132 is lowered, the roller 142 comes into contact with the upper surface of a plate-like engaged portion 146 provided at the nozzle holder 94, pushes the nozzle holder 94 down against a biasing force of the spring 120, and lowers the suction nozzle 96. When the first lifting and lowering member 132 is lifted, the nozzle holder 94 is allowed to be lifted by the biasing of the spring 120. Accordingly, the suction nozzle 96 is lifted. The nozzle lifting and lowering device 128 is a device that forcibly lowers the suction nozzle 96 but allows the suction nozzle 96 to be lifted. The nozzle lifting and lowering device may be a device that lifts and lowers the suction nozzle 96 and forcibly moves the suction nozzle 96.

The nozzle lifting and lowering device 130 has the same structure as the nozzle lifting and lowering device 128, and includes a lifting and lowering member 152, a feed screw mechanism 158 that includes a feed screw 154 and a nut 156, and an electric motor 160 as shown in Fig. 3. The lifting and lowering member 152 is moved to an arbitrary position in the vertical direction while being guided by a guide rod 162. A roller 164 (see Fig. 4) is rotatably mounted on the lifting and lowering member 152 and forms an engaging portion.

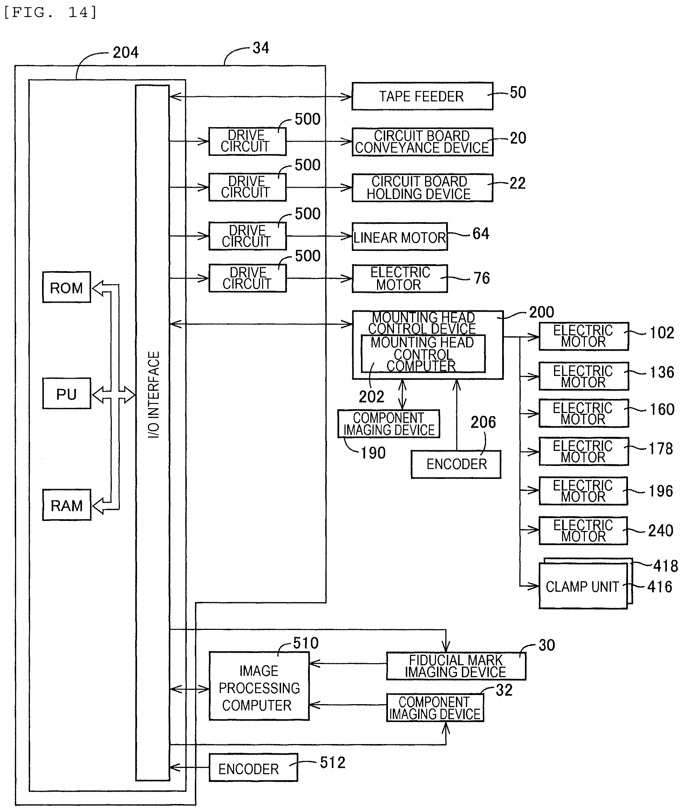

The switching of the control valve device 110 is performed at the component take-out position and the component mounting position. For this purpose, a valve switching device 172 is provided at a portion of the head body 88 corresponding to the component mounting position as shown in Fig. 4. The valve switching device 172 includes a switching member 174 and a switching member drive device 176. The switching member drive device 176 uses an electric motor 178 (see Fig. 14) as a driving source and rotates the switching member 174 about an axis orthogonal to the axis of rotation of the rotating body 100 in both normal and reverse directions. Accordingly, two engaging portions 180 and 182, which are formed of rollers of the switching member 174, are selectively engaged with a plate-like engaged portion 184 of the valve spool 112, so that the valve spool 112 is lowered or lifted relative to the nozzle holding portion 108. The switching of the control valve device 110 at the component take-out position will be described below.

A component imaging device 190 is provided at the component imaging position as shown in Fig. 3. A camera 192 of the component imaging device 190 images a component, which is taken out of the tape feeder 50 or the bulk feeder 90 by the suction nozzle 96, through a reflection device (not illustrated). Further, a nozzle rotation-driving device 194 is provided on the head body 88, and rotates the suction nozzle 96 by rotating the nozzle holder 94 about the axis of the nozzle holder 94. The nozzle rotation-driving device 194 is a device that uses an electric motor 196 as a driving source and simultaneously rotates all of the twelve nozzle holders 94.

Furthermore, the head body 88 is further provided with a mounting head control device 200 (see Fig. 14). The mounting head control device 200 includes a mounting head control computer 202 as a main component, and is connected to a module control computer 204 that forms a main component of the module control device 34. The mounting head control device 200 controls the electric motor 102, which is formed of a servo motor with an encoder, and the like through a drive circuit (not illustrated) . Each encoder 206 of the electric motor 102 and the like is connected to the mounting head control computer 202 as the one that is representatively shown.

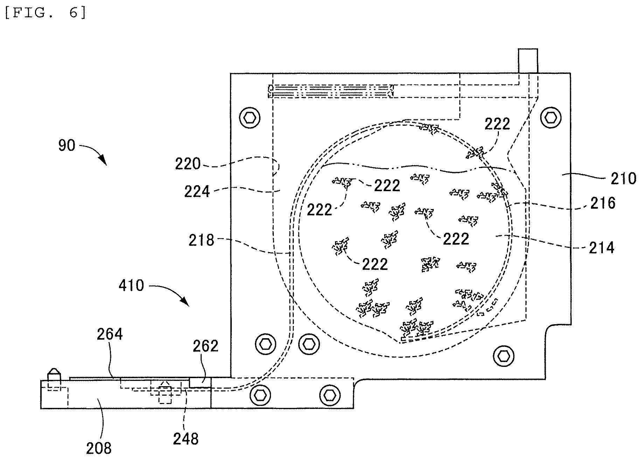

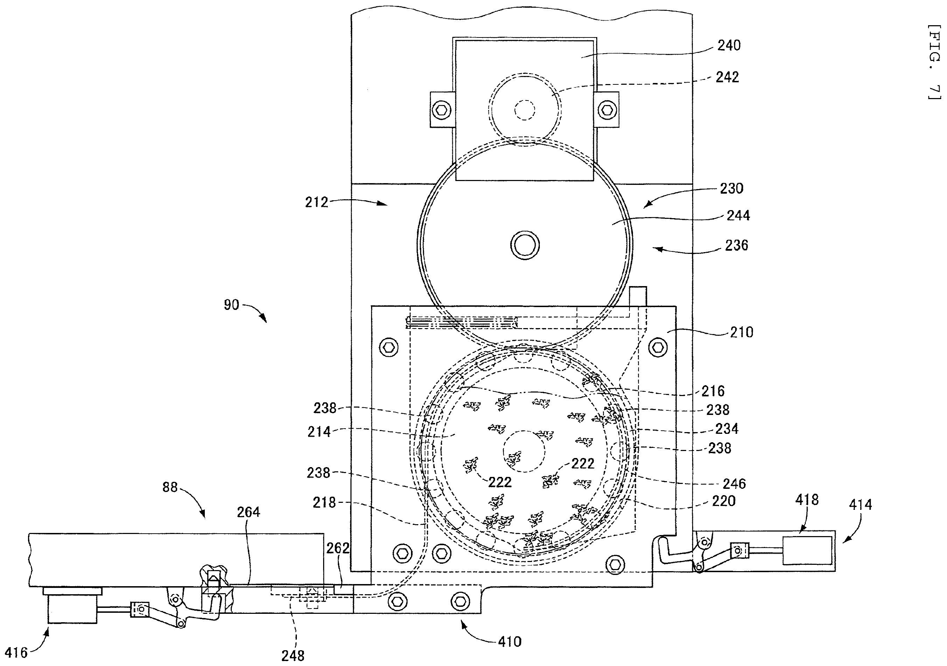

The bulk feeder 90 will be described. The bulk feeder 90 is provided at a portion of the head body 88 corresponding to the component take-out position as shown in Fig. 5, and is moved together with the mounting device 92 by the head moving device 28. As shown in Figs. 6 and 7, the bulk feeder 90 includes a base 208, a component case 210, and a component feed device 212. The component case 210 is provided with a storage chamber 214, a guide groove 216, a guide passage 218, and a recessed portion 220. A plurality of components 222 are stored in the storage chamber 214 as bulk components in bulk. Leadless electronic circuit components without leads are stored as the components 222. For example, components (chip components), which include electrodes made of a magnetic material, such as capacitors or resistors are stored. The recessed portion 220 is opened to the upper surface and the back surface of the component case 210, and is partitioned from the storage chamber 214 by a bottom wall portion 224 of the recessed portion 220.

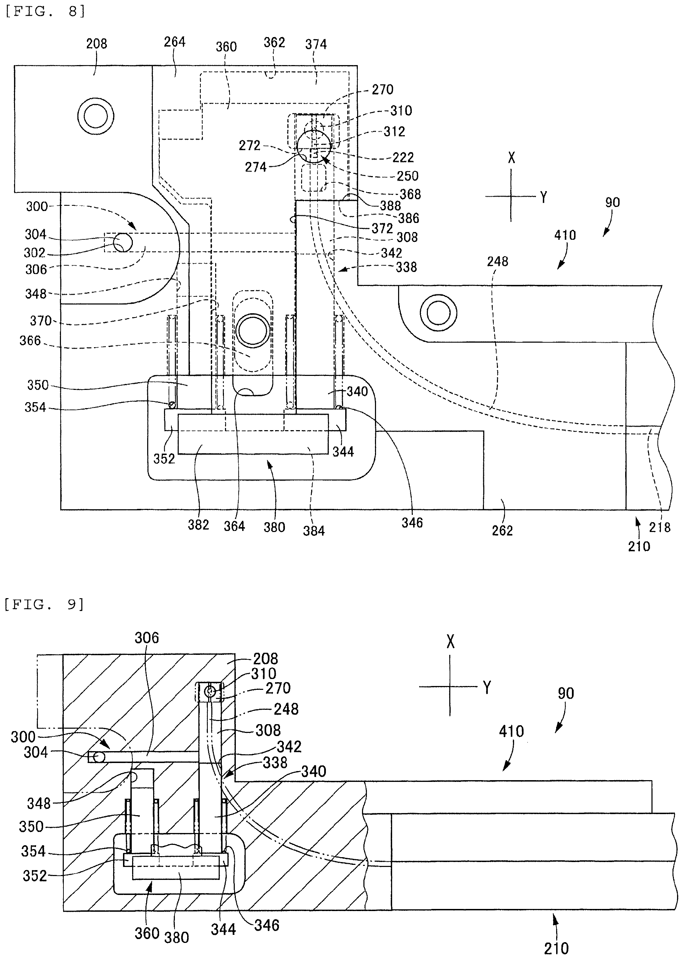

The component feed device 212 includes a bulk component drive device 230 shown in Fig. 7. The bulk component drive device 230 is provided at the head body 88, and includes a turntable 234 and a turntable drive device 236. The turntable 234 is received in the recessed portion 220 of the component case 210, and a plurality of, for example, three or more permanent magnets 238 are held on the side surface of the turntable 234. The turntable drive device 236 uses an electric motor 240 as a driving source and the rotation of the turntable drive device 236 is transmitted to the turntable 234 by gears 242, 244, and 246. Accordingly, the turntable drive device 236 rotates the turntable 234 by an arbitrary angle in both normal and reverse directions. Therefore, the components 222 stored in the storage chamber 214 are attracted by the permanent magnets 238 and are moved from the lower side to the upper side; and some of the components 222 are fitted into the guide groove 216, enter the guide passage 218 from the guide groove 216, and are moved while being aligned in a line. The components 222 eventually enter a guide passage 248 (see Fig. 8) provided in the base 208, and are moved to a component supply section 250.

As shown in Figs. 7 and 8, the base 208 is formed in the shape of a block and the component case 210 is fixed to the base 208. A groove, which is opened to the upper surface of the base 208, is formed in the base 208 and is closed by covers 262 and 264 fixed to the base 208. As a result, the guide passage 248 is formed. As shown in Fig. 8, one end of the guide passage 248 communicates with the guide passage 218 of the component case 210, the other end portion of the guide passage 248 is formed parallel to the X-axis direction, and a tip of the other end portion of the guide passage 248 is positioned below the suction nozzle 96 that is stopped at the component take-out position. As a result, the component supply section 250 is formed. The movement of the components 222 in the guide passage 248 is stopped by a stopper 270 that is fixed to the base 208. The stopper 270 is orthogonal to the guide passage 248, includes a vertical stopper face 272, and stops the leading component 222 at the component supply section 250. An opening 274 is formed at a portion of the cover 264 corresponding to the component supply section 250.

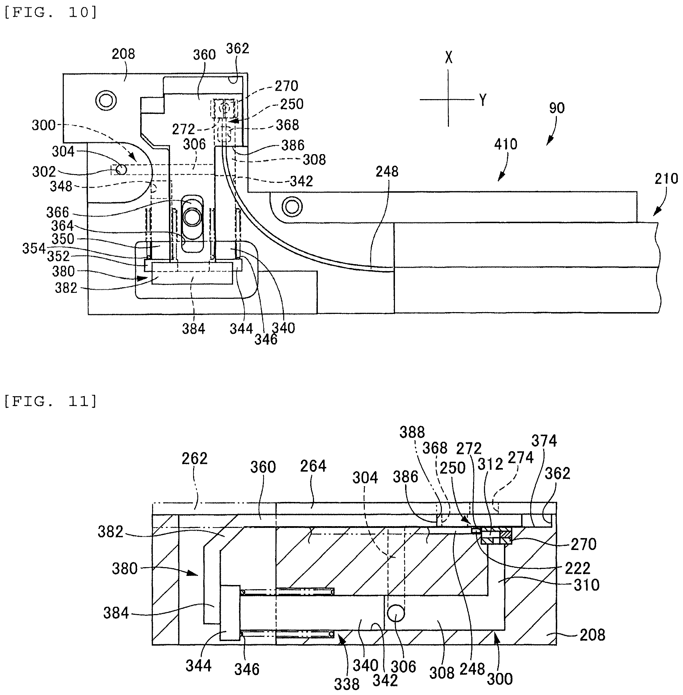

A negative pressure supply passage 300 is formed in the base 208 as shown in Fig. 9. One end of the negative pressure supply passage 300 is opened to an upper surface of a portion of the base 208, which is positioned on the upstream side of the component supply section 250 in a component feed direction, and forms a connection port 302 (see Fig. 8). A passage portion 304 (see Fig. 11) extends downward from the connection port 302, a passage portion 306 extends toward the guide passage 248 from a lower end portion of the passage portion 304 in parallel with the Y-axis direction, and a passage portion 308 extends toward the component supply section 250 from an extending end portion of the passage portion 306 in parallel with the X-axis direction. As shown in Fig. 11, the passage portion 308 is allowed to communicate with one end portion of a passage 312, which is formed in the stopper 270, by a vertical passage portion 310. The other end portion of the passage 312 is opened to the stopper face 272. The cross-sectional shape of the passage 312 is the shape of a circle of which the diameter is smaller than the width of the component 222 (the dimension of the guide passage 248 in a direction orthogonal to the component feed direction) in this embodiment, and an upper half of the passage 312 faces the guide passage 248. A joint member (not illustrated) is connected to the connection port 302 and is allowed to communicate with the negative pressure source. Accordingly, air, which is present in the guide passage 248, is sucked through the passage portions 304, 306, 308, and 310 and the passage 312, so that the component 222 is sent to the component supply section 250. In this case, the component 222 is stopped when coming into contact with the stopper face 272.

The base 208 is provided with a component feeding-negative pressure control valve 338 as shown in Fig. 9. The component feeding-negative pressure control valve 338 is formed of a spool valve in this embodiment, and includes a valve spool 340 that forms a movable portion. The passage portion 308 extends toward the side opposite to the component supply section 250, so that a spool hole 342 is formed in the base 208. One end portion of the valve spool 340 is fitted into the spool hole 342 so as to be movable in the X-axis direction. The valve spool 340 is biased in a direction away from the passage portion 306 by a compression coil spring 346 provided between a head portion 344 of the valve spool 340, which protrudes from the base 208, and the base 208. Further, a rod hole 348 is formed in the base 208 in parallel with the spool hole 342, and a rod 350 is movably fitted into the rod hole 348. The rod 350 is biased in a direction to protrude from the rod hole 348 by a compression coil spring 354 that is provided between a head portion 352 of the rod 350 and the base 208.

As shown in Fig. 11, a shutter 360 is provided between the base 208 and the cover 264. The shutter 360 is fitted into a recessed portion 362, which is formed in the base 208 as shown in Fig. 8, so as to be movable in the X-axis direction. A portion of one side surface of the recessed portion 362 is formed of a cover 262 and the movement of the shutter 360 is guided by side surfaces 370 and 372 of the recessed portion 362 that are formed of the base 208 and the cover 262 and are parallel to the X-axis direction, a bottom 374 of the recessed portion 362, and the cover 264. Further, the shutter 360 is fitted to a protruding portion 366, which is formed on the bottom 374 of the recessed portion 362, in an elongated hole 364 so as to be movable in the X-axis direction. Furthermore, an opening 368, which allows the component supply section 250 to be opened upward, is formed at the shutter 360.

As shown in Figs. 10 and 11, one end portion of the shutter 360 in a moving direction, that is, a rear end portion, which is an end portion of the shutter opposite to the side where the opening 368 is formed, protrudes from the recessed portion 362. As a result, a driven portion 380 is formed. As shown in Fig. 11, the driven portion 380 includes an inclined portion 382 that is inclined downward toward the rear side and an extending portion 384 that extends vertically downward from the inclined portion 382, and is fixed to the head portions 344 and 352 of the valve spool 340 and the rod 350 at the extending portion 384. Accordingly, the shutter 360, the valve spool 340, and the rod 350 are integrally moved. Meanwhile, the movement of the shutter 360 may be guided by the sliding of the valve spool 340 and the rod 350 on the base 208. Further, the protruding portion 366, which is formed in the recessed portion 362, may be used to guide the movement of the shutter 360.

The shutter 360 is biased together with the valve spool 340 and the rod 350 by the springs 346 and 354. As shown in Fig. 8, backward limits, which are the limits of the movement of the valve spool 340, the rod 350, and the shutter 360 caused by the biasing of the springs, are defined depending on the contact between an end face 386 of the shutter 360, which is parallel to the Y-axis direction, and a side surface 388 of the cover 262 that is parallel to the Y-axis direction. In this state, the valve spool 340 deviates from the passage portion 306 of the negative pressure supply passage 300 so as to allow the passage portion 306 to communicate with the passage portion 308, and is positioned at a component feeding-negative pressure supply position where the supply of component feeding-negative pressure to the guide passage 248 is allowed. Accordingly, the component feeding-negative pressure control valve 338 is in a component feeding-negative pressure supply state. The shutter 360 is positioned at a closing position where the opening 368 deviates from the component supply section 250 and is positioned in the rear of the component supply section 250 in the moving direction of the shutter and a portion of the shutter 360 forming the opening 368 closes the component supply section 250.

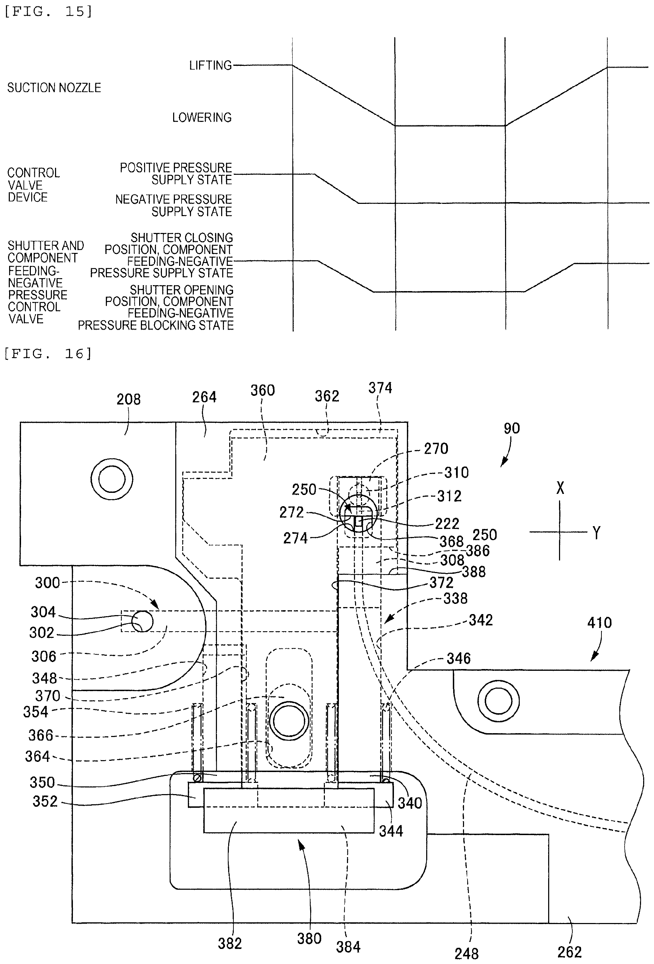

The valve spool 340, the rod 350, and the shutter 360 move forward against the biasing forces of the springs 346 and 354, and the forward limits thereof are defined depending on the contact between an end face of the elongated hole 364 and the protruding portion 366 as shown in Fig. 16. In this state, the valve spool 340 closes the passage portion 306 so as to block the communication between the passage portion 306 and the passage portion 308, and is positioned at a component feeding-negative pressure blocking position where the supply of negative pressure to the guide passage 248 is blocked. Accordingly, the component feeding-negative pressure control valve 338 is in a component feeding-negative pressure blocking state. The shutter 360 is positioned at an opening position where the opening 368 is positioned on the component supply section 250, is positioned in the opening 274 of the cover 264, and the component supply section 250 is opened to the outside.

The base 208 and the component case 210 of the bulk feeder 90, which are fixed to each other, form a component case 410 with a passage, and can be separated from the bulk component drive device 230 that is provided at the head body 88 while the components 222 are stored in the component case 210. A mounting device 414 for the component case with a passage, which is a feeder holding device, is provided at the head body 88 as shown in Fig. 7, so that a feeder holding portion is formed. The component case 410 with a passage is positioned in the horizontal and vertical directions by the head body 88, and is detachably held. The mounting device 414 for the component case with a passage includes a pair of clamp units 416 and 418 in this embodiment, and holds and releases the component case 410 with a passage . The component case 410 with a passage is mounted on the head body 88 and functions as the bulk feeder 90 while the components 222 present in the component case 210 are driven by the bulk component drive device 230.

Components 222 are supplied to the electronic circuit component mounting device by plural kinds of bulk feeders 90. The kinds of bulk feeders 90 vary depending on, for example, the kinds of components 222 to be supplied. The depth of the guide passage 248 is set to a dimension corresponding to the height of the component 222, and the height positions of the upper surfaces of the components 222 guided to the component supply section 250 by the guide passage 248 are set to be equal to each other even though the kinds of the components 222 vary. The bulk component drive device 230 is common to a plurality of bulk feeders 90 of which the kinds vary. In this embodiment, the component case 410 with a passage is selectively held on the plural kinds of bulk feeders 90 by one mounting device 414 for the component case with a passage that is provided at the head body 88, so that the bulk feeder 90 supplies the components 222. An exchange device (not illustrated) is provided in this embodiment, and plural kinds of component cases 410 with passages are automatically mounted on and removed from the head body 88 by the operation of the exchange device and the mounting device 414 for the component case with a passage. The exchange device has the same structure as an exchange device disclosed in the specification of PCT/JP2012/074105. The exchange device is unitized and is mounted on the component supply stage together with the tape feeders 50. When at least a component storage portion of the bulk feeder is adapted to be removable from a head body as described above, the bulk feeder can cope with the supply of components and the change of the kinds of components to be supplied. The bulk component drive device of the bulk feeder may be formed integrally with the component case and the base so that the bulk feeder is mounted on and removed from the head body.

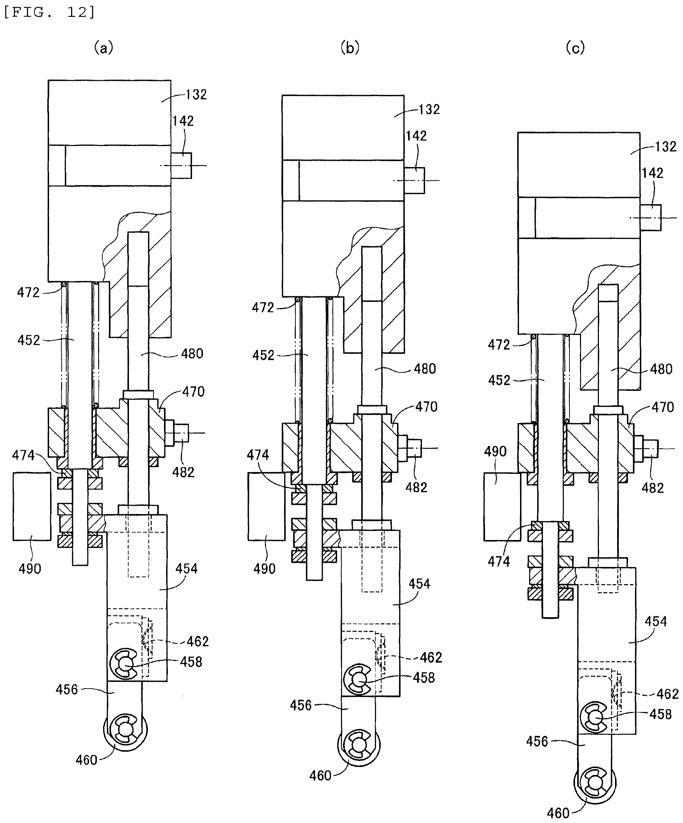

In the electronic circuit component mounting device, the movement of the shutter 360 of the bulk feeder 90, the control of the component feeding-negative pressure control valve 338, and the switching of the control valve device 110 at the component take-out position are performed in mechanical synchronization with the lifting and lowering of the suction nozzle 96. For this reason, as shown in Fig. 5, a rod 452, which is a support member, is fixed to the first lifting and lowering member 132 of the nozzle lifting and lowering device 128 in parallel to the axis of the suction nozzle 96 that is held by the nozzle holder 94 so as to extend downward. A shutter/spool drive member 456 is mounted on a bracket 454, which is fixed to the lower end portion of the rod 452, by a shaft 458 so as to be rotatable about an axis parallel to the Y-axis direction. A roller 460 as a rotary engaging member, which is an engaging member, is mounted on a portion of the shutter/spool drive member 456, which extends downward from the shaft 458, so as to be rotatable about an axis parallel to an axis of rotation of the shutter/spool drive member 456. The roller 460 is biased toward the rotating body 100 by a spring, for example, a leaf spring 462, as an elastic member, which is a type of a biasing device provided between the bracket 454 and the shutter/spool drive member 456 as shown in Fig. 12 (a) . The limit of rotation of the shutter/spool drive member 456, which is caused by the biasing of the spring, is defined depending on the contact between the shutter/spool drive member 456 and the bracket 454 as shown in Fig. 12; and the shutter/spool drive member 456 is orthogonal to the axis of rotation thereof and is positioned at a normal position where a direction in which the shaft 458 and the roller 460 are arranged is a vertical direction.

As schematically shown in Fig. 12 (a), a second lifting and lowering member 470 is fitted to a portion of the rod 452, which is positioned between the first lifting and lowering member 132 and the bracket 454, so as to be relatively movable in the axial direction. Accordingly, the second lifting and lowering member 470 can be lifted and lowered relative to the first lifting and lowering member 132. The second lifting and lowering member 470 is biased in a direction away from the first lifting and lowering member 132 by a compression coil spring 472 that is disposed between the first lifting and lowering member 132 and the second lifting and lowering member 470 and is fitted to the rod 452. The limit of separation of the second lifting and lowering member 470 from the first lifting and lowering member 132, which is caused by the biasing of the spring 472, is defined depending on the contact between the second lifting and lowering member 470 and a large-diameter stopper portion 474 fixed to the rod 452.

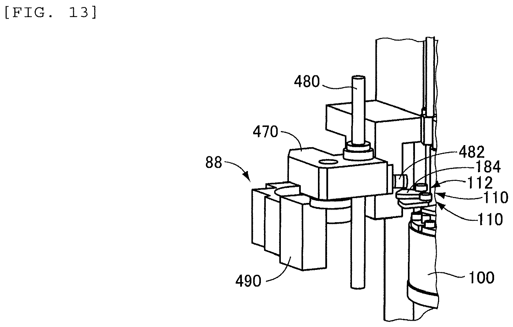

A rod 480 is fitted and fixed to the second lifting and lowering member 470 in parallel with the rod 452. An upper end portion of the rod 480 is fitted into the first lifting and lowering member 132 so as to be relatively movable in the axial direction, and a lower end portion of the rod 480 is fitted into the bracket 454 so as to be relatively movable in the axial direction. Accordingly, the rotation of the second lifting and lowering member 470 about the vertical axis is prevented, so that the second lifting and lowering member 470 is positioned in the horizontal direction. A roller 482 is mounted on the second lifting and lowering member 470 so as to be rotatable about an axis orthogonal to the axis of rotation of the rotating body 100 as shown in Figs. 12 and 13, so that an engaging portion is formed. In addition, a stopper 490 is provided on the head body 88 below the second lifting and lowering member 470 on a lifting and lowering path of the second lifting and lowering member 470 so that the position of the stopper 490 is fixed.

As shown in Fig. 14, the module control device 34 controls driving sources of various devices of the mounting module 10 and the like, such as the linear motor 64, through a drive circuit 500. An image processing computer 510 that processes data obtained from the imaging of the fiducial mark imaging device 30 and the component imaging device 32, encoders 512 (one encoder is representatively shown in Fig. 14) provided on the electric motors 76 and the like of the X-axis slide moving devices 74, the mounting head control computer 202, and the like are connected to an I/O interface of the module control computer 204. Meanwhile, the imaging data of the component imaging device 190 of the mounting head 26 are sent to the image processing computer 510 and processed by the image processing computer 510, and necessary data are sent to the mounting head control computer 202. In addition, various programs, data, and the like, which are required to mount components on the board 44, are stored on an RAM of the module control computer 204.

In the mounting module 10 having the above-mentioned structure, as one aspect of the mounting of a component on the board 44, the suction nozzle 96 takes the component 222 out of the bulk feeder 90 and mounts the component 222 on the board 44. The bulk feeder 90 supplies the components 222 while moving together with the mounting device 92. While the component 222 is not taken out of the bulk feeder 90, the shutter 360 is positioned at the closing position as shown in Fig. 8 and the valve spool 340 is positioned at the component feeding-negative pressure supply position. Accordingly, air, which is present in the guide passage 248, is sucked, so that the components 222 are sent. In this case, the leading component 222 is positioned at the component supply section 250 when coming into contact with the stopper face 272. The opening 274 is closed by the shutter 360, so that the loss of negative pressure in the guide passage 248 is suppressed and the jumping of the component 222 out of the component supply section 250 is prevented. The opening 368 of the shutter 360 is closed by the cover 264, so that the loss of negative pressure is suppressed. In addition, the first lifting and lowering member 132 of the nozzle lifting and lowering device 128 is positioned at a lifting end position as shown in Fig. 12 (a), the second lifting and lowering member 470 comes into contact with the stopper portion 474 due to the biasing of the spring 472, and the shutter/spool drive member 456 is positioned at the normal position. The control valve device 110 corresponding to the suction nozzle 96, which does not hold the component 222, is in the positive pressure supply state.

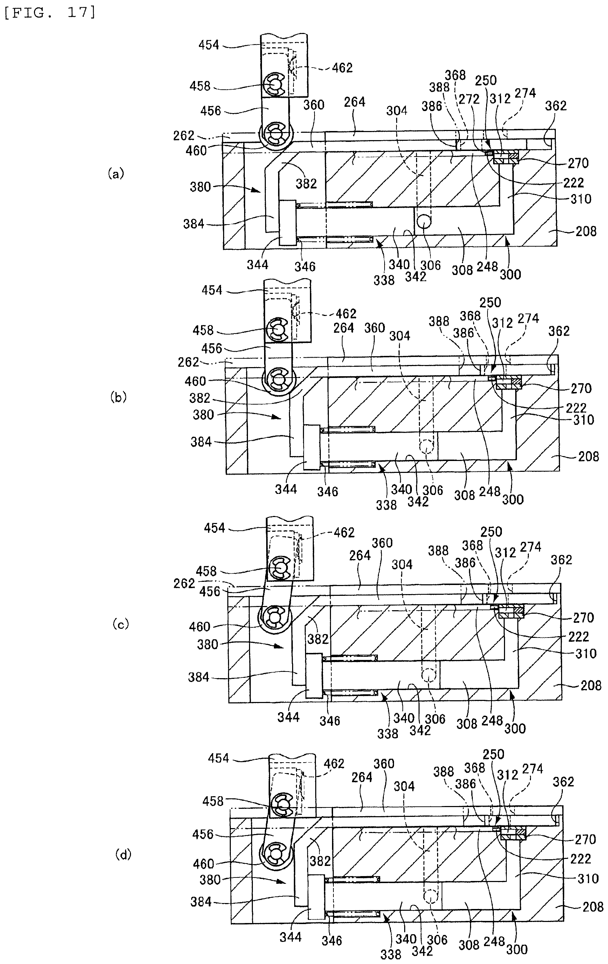

Since the rotating body 100 is intermittently rotated, the twelve suction nozzles 96 sequentially revolve to the component take-out position and are sequentially lowered by the nozzle lifting and lowering device 128. The first lifting and lowering member 132 of the nozzle lifting and lowering device 128 is lowered, and the roller 142 is engaged with the engaged portion 146 of the nozzle holder 94 and is pushed down. In this case, the shutter/spool drive member 456 and the second lifting and lowering member 470 are lowered, the roller 482 is engaged with the engaged portion 184 of the valve spool 112 and is pushed down, and the control valve device 110 is switched to the negative pressure supply state from the positive pressure supply state. Since the rollers 142 and 482 are rotated, the suction nozzles 96 and the valve spools 112 can be lowered while revolving. Further, as shown in Fig. 17(a), the roller 460 of the shutter/spool drive member 456 is engaged with the inclined portion 382 of the shutter 360, the shutter 360 is moved forward by the action of an inclined surface and is moved to the opening position, and the valve spool 340 is moved to the component feeding-negative pressure blocking position.

As shown in a cycle diagram of Fig. 15, the lifting and lowering of the suction nozzle 96, the switching of the control valve device 110, and the movement of the shutter 360 and the valve spool 340 are performed in parallel and are performed in synchronization. After the suction nozzle 96 starts to be lowered, the second lifting and lowering member 470 starts to push the valve spool 112 down. Then, the roller 460 is engaged with the inclined portion 382 and the shutter 360 and the valve spool 340 start to be moved forward. Before the valve spool 112 reaches a lowering end position, the control valve device 110 is switched to a suction-negative pressure supply state. When the second lifting and lowering member 470 comes into contact with the stopper 490 as shown in Fig. 12 (b), the lowering of the second lifting and lowering member 470 is stopped.

After the second lifting and lowering member 470 is stopped, the first lifting and lowering member 132 is further lowered as shown in Fig. 12(c). Accordingly, the suction nozzle 96 and the shutter/spool drive member 456 are further lowered. This lowering is allowed by the lowering of the first lifting and lowering member 132 relative to the second lifting and lowering member 470 and the lowering of the first lifting and lowering member 132 relative to the rod 480 that are caused by the compression of the spring 472. As shown in Figs. 16 and 17(b), the shutter 360 and the valve spool 340 are moved to the opening position and the component feeding-negative pressure blocking position and are stopped, respectively, before the suction nozzle 96 reaches the lowering end position. The first lifting and lowering member 132 is further lowered from this state, and the suction nozzle 96 sucks the component 222. The shutter/spool drive member 456 is rotated against the biasing force of the leaf spring 462 in a direction in which the roller 460 is separated from the shutter 360 as shown in Fig. 17 (c), so that the lowering of the first lifting and lowering member 132 is allowed. After the roller 460 is moved along the inclined portion 382, the shutter/spool drive member 456 is moved down along the extending portion 384 as shown in Fig. 17 (d) and maintains the shutter 360 and the valve spool 340, which are positioned at the opening position and the component feeding-negative pressure blocking position, by the biasing force of the leaf spring 462. Accordingly, when the suction nozzle 96 reaches the lowering end position, component suction-negative pressure is supplied to the suction nozzle 96, the component supply section 250 is opened in the bulk feeder 90, and the suction nozzle 96 comes into contact with the component 222 through the openings 274 and 368 and can suck the component 222.

Since the first lifting and lowering member 132 is lifted after the first lifting and lowering member 132 is lowered to the lowering end position and is stopped for a set time, the suction nozzle 96 is lifted and the component 222 is taken out of the component supply section 250 through the openings 368 and 274. The shutter/spool drive member 456 can be lifted together with the first lifting and lowering member 132, but the roller 460 is lifted along the extending portion 384 at the beginning of lifting. Further, when the roller 460 is in a state in which the roller 460 is lifted along the inclined portion 382, the shutter/spool drive member 456 is rotated by the biasing of the leaf spring 462, comes into contact with the bracket 454, and returns to a state in which the shutter/spool drive member 456 is positioned at the normal position. Accordingly, since the biasing force of the leaf spring 462 does not act on the shutter 360, the backward movement of the shutter 360 caused by the biasing of the springs 346 and 354 is allowed.

Until the shutter/spool drive member 456 returns to the normal position after starting to be lifted as described above, the shutter 360 is moved forward and is maintained while stopping. The shutter 360 and the valve spool 340 are maintained in a state in which the shutter 360 and the valve spool 340 are positioned at the opening position and the component feeding-negative pressure blocking position, respectively. Accordingly, since the component supply section 250 is opened when the suction nozzle 96 is lifted, the suction nozzle 96 can take the component 222 out. Further, since the supply of component feeding-negative pressure into the guide passage 248 is cut off, the suction nozzle 96 can take the component 222 out while pushing of the component 222 toward the stopper face 272 caused by negative pressure is released. For this reason, the suction nozzle 96 can reliably take the component 222 out without pushing of the leading component 222 toward the stopper face 272 or the catch of the component 222 between the subsequent component 222 and the stopper face 272 and the falling of the component 222 or the bringing of the subsequent component 222 that is caused by the friction between the component 222 sucked by the suction nozzle 96 and the stopper face 272.

As the shutter/spool drive member 456 is further lifted from a state in which the shutter/spool drive member 456 is rotated to the normal position, the shutter 360 and the valve spool 340 are moved backward and are moved to the closing position and the component feeding-negative pressure supply position, respectively. The first lifting and lowering member 132 is lifted relative to the second lifting and lowering member 470 and the rod 480 until the stopper portion 474 comes into contact with the second lifting and lowering member 470. After the stopper portion 474 comes into contact with the second lifting and lowering member 470, the second lifting and lowering member 470 is lifted together with the first lifting and lowering member 132. Accordingly, the roller 482 is separated from the valve spool 112. The control valve device 110 is maintained in a state in which the valve spool 112 is lowered and is switched to the negative pressure supply state. Before the suction nozzle 96 reaches the lifting end position, the shutter/spool drive member 456 is separated from the shutter 360, the shutter 360 is positioned at the closing position, and the component feeding-negative pressure control valve 338 is in the component feeding-negative pressure supply state. Then, the suction nozzle 96 is lifted to the lifting end position and the rotating body 100 is rotated. After that, the suction nozzle 96, which takes the component 222 out, is moved to the component take-out position.

The suction nozzle 96, which sucks the component 222, is imaged at the component imaging position by the component imaging device 190, and a holding position error of the component 222 is calculated. The suction nozzle 96 is lowered at the component mounting position by the nozzle lifting and lowering device 130, and mounts the component 222 on the board 44. At this time, the holding position error of the component 222 held by the suction nozzle 96 and a position error of a component mounting portion on the board 44, which is obtained from the imaging of a fiducial mark, are corrected. The switching member 174 is rotated at the component mounting position by the switching member drive device 176 of the valve switching device 172, the valve spool 112 is lifted relative to the rotating body 100, and the control valve device 110 is switched to the positive pressure supply state from the negative pressure supply state. Accordingly, the supply of negative pressure to the suction nozzle 96 is cut off and positive pressure is supplied to the suction nozzle 96, so that the component 222 is positively released. The rotating body 100 starts to be rotated after the mounting of the component, and the switching member 174 is rotated after the valve spool 112 deviates from the switching member 174. Then, the switching member 174 returns to a position where the switching of the control valve device 110 corresponding to the suction nozzle 96 moved to the component mounting position is started.

The bulk feeder 90 is adapted so that the positions of the upper surfaces of the components 222 in the height direction are the same at the component supply section 250 even though the kinds of the components 222 vary. For this reason, even though the kinds of components 222 taken out by the suction nozzles 96 vary, the lifting and lowering stroke of the first lifting and lowering member 132 of the nozzle lifting and lowering device 128 at the component take-out position and the switching timing of the control valve device 110 are the same. Accordingly, the lifting and lowering of the suction nozzle 96, the supply of component suction-negative pressure, the opening and closing of the shutter 360, and the blocking and supply of component feeding-negative pressure can be mechanically synchronized in the same manner in any bulk feeder 90.

However, since the positions of the upper surfaces, which are the component mounting surfaces of the boards 44 held by the circuit board holding devices 22, in the height direction are the same even though the heights of the components 222 vary, the switching timing of the control valve device 110 at the component mounting position is changed according to the heights of the components 222. As the height of the component 222 increases, the switching of the control valve device 110 to the positive pressure supply state from the negative pressure supply state, which is performed by the valve switching device 172, is performed earlier so that positive pressure is supplied to the suction nozzle 96 when the component 222 is placed on the board 44.

As apparent from the above description, in this embodiment, the component case 210 forms the component storage portion; and the guide groove 216, the guide passages 218 and 248, the bulk component drive device 230, the negative pressure supply passage 300, and the component feeding-negative pressure control valve 338 form the component feed device 212 as a component feed portion. Further, the electric motor 136 of the nozzle lifting and lowering device 128 forms one actuator; a structure in which the shutter/spool drive member 456 is held by the bracket 454 so as to be rotatable relative to the first lifting and lowering member 132 forms a final nozzle lowering allowance device; a structure in which the shutter/spool drive member 456 is mounted on the first lifting and lowering member 132 so as to be lifted and lowered together with the first lifting and lowering member 132 forms a nozzle/shutter synchronizing portion; and a structure in which the valve spool 340 is fixed to the shutter 360 so as to be moved integrally forms a shutter/component feeding-negative pressure control valve synchronizing portion. Furthermore, the stopper portion 474 forms a separation limit defining device; the stopper 490 forms a lowering limit defining device; and the first lifting and lowering member 132, the second lifting and lowering member 470, and the spring 472, which is the biasing device, form a nozzle/suction-negative pressure control valve synchronizing portion together. The final nozzle lowering allowance device and the like form a mechanical synchronization device.

Meanwhile, negative pressure does not necessarily need to be used to feed the components 222, which are present in the guide passage 248 of the bulk feeder, to the component supply section 250. For example, positive pressure may be used as described in the specification of Japanese Patent Application No. 2011-206452. If negative pressure and positive pressure are referred to as component feeding-gas pressure, the component feeding-negative pressure control valve 338 should be referred to as a component feeding-pressure control valve. Further, the shutter/component feeding-negative pressure control valve synchronizing portion should be referred to as a shutter/component feeding-pressure control valve synchronizing portion.

Furthermore, the lowering of the suction nozzles does not necessarily need to be mechanically synchronized with the start of the supply of component suction-negative pressure to the suction nozzles . At least only a part of operations for supplying components by the bulk feeder may be mechanically synchronized. In this case, it is possible to form the suction-negative pressure control valve without considering mechanical synchronization. For example, the suction-negative pressure control valve may be formed so as to be the same as the embodiment, a valve switching device including a dedicated driving source may be provided, and the suction-negative pressure control valve may be switched by the valve switching device. Alternatively, the suction-negative pressure control valve may be formed of a solenoid valve. Moreover, the lowering of the suction nozzles also does not necessarily need to be synchronized with at least a part of operations for supplying components by the bulk feeder, and only the start of the supply of component suction-negative pressure to the suction nozzles may be synchronized with the lowering of the suction nozzles. In this case, the bulk feeder does not need to necessarily include the shutter and the component feeding-pressure control valve, and may not include at least one of the shutter and the component feeding-pressure control valve.

The shutter may be omitted regardless of whether or not the lowering of the suction nozzles is mechanically synchronized with at least a part of operations for supplying components by the bulk feeder, and the component feed portion may feed components by the movement of a belt or the application of vibrations. This feeding of components is performed after components are taken out by the suction nozzles, and a non-operating state is made after the feeding of components. Accordingly, unlike in the case in which components are fed by the supply of negative pressure, components may be fed while the lowering of the suction nozzles is not mechanically synchronized with the supply of negative pressure. However, the structure of the feed device can be adapted so that the preparation of feeding is performed in mechanical conjunction with the lowering of the suction nozzles and the feeding of components is performed in mechanical conjunction with the lifting of the components.

When components are fed by the supply of component feeding-gas pressure to the guide passage, the supply of component feeding-gas pressure may be blocked and the guide passage may be opened to the atmosphere in synchronization with the lowering of the suction nozzles. For example, the valve spool is adapted to block the guide passage from a negative pressure source or a positive pressure source and to allow the guide passage to communicate with the atmosphere by the forward movement of the valve spool. Alternatively, two valve spools are provided to supply and block component feeding-gas pressure and to open and block the guide passage to and from the atmosphere, respectively.

When the bulk feeder includes plural kinds of bulk feeders, these bulk feeders may be held together with the head body and may be selectively held by the same feeder holding portion of the head body. In the former case, the bulk feeders do not necessarily need to be detachably held on the feeder holding portion of the head body. Further, for example, the plural kinds of bulk feeders are moved on the head body by the moving device so that each component supply section is selectively positioned below a suction nozzle positioned at the component take-out position. A plurality of bulk feeders of the same kind may be held on the head body.

### Reference Signs List

26: MOUNTING HEAD, 90: BULK FEEDER, 92: MOUNTING DEVICE, 88: HEAD BODY, 96: SUCTION NOZZLE, 110: CONTROL VALVE DEVICE, 128: NOZZLE LIFTING AND LOWERING DEVICE

## Claims

1. An electronic circuit component mounting device comprising:
a circuit substrate holding device (22) that detachably holds a circuit substrate (44);
a bulk feeder (90) that includes (a) a component storage portion (210) storing electronic circuit components (222) in bulk and (b) a component feed portion (212) aligning the electronic circuit components (222), which are stored in the component storage portion (210), in a guide passage (248) in a line and feeding the electronic circuit components (222) to a component supply section (250);
a mounting device (92) that includes (a) a suction nozzle (96) sucking and holding the electronic circuit component (222) by negative pressure, (b) a suction-negative pressure control valve (110) controlling the supply of component suction-negative pressure to the suction nozzle (96), and (c) a nozzle lifting and lowering device (128, 130) lifting and lowering the suction nozzle, and takes the electronic circuit components (222) out of the component supply section (250) of the bulk feeder (90) one by one by the suction nozzle (96) and mounts the electronic circuit component (222) on the circuit substrate (44) held by the circuit substrate holding device (22);
a head body (88) that is provided so as to be movable relative to the circuit substrate holding device (22) and forms a mounting head (26) together with the bulk feeder (90) and the mounting device (92);
a head moving device (28) that moves the mounting head (26) relative to the circuit substrate holding device (22) by moving the head body (88);
**characterized by**
one actuator (136); and
a mechanical synchronization device that mechanically synchronizes (A) the lowering of the suction nozzle (96) with (B) at least one of (a) at least a part of operations for supplying the components (222) by the bulk feeder (90) and (b) the start of supplying of component suction-negative pressure, which is performed by the suction-negative pressure control valve (110), by mechanically transmitting the motion of the actuator (136) to the nozzle lifting and lowering device (128), and at least one of the bulk feeder (90) and the suction-negative pressure control valve (110),
wherein the mechanical synchronization device mechanically transmits the motion of the actuator (136) to at least one of (i) a shutter (360), which is movable to a closing position where the component supply section (250) is closed and an opening position where the component supply section (250) is opened, and (ii) a component feeding-pressure control valve (338), which controls component feeding-gas pressure to be supplied to the guide passage (248), of the bulk feeder (90), thereby mechanically synchronizing a lowering motion of the suction nozzle (96) with at least one of the movement of the shutter (360) to the opening position and the blocking of the component feeding-gas pressure that is performed by the component feeding-pressure control valve (338).

2. The electronic circuit component mounting device according to claim 1,
wherein a portion, which transmits the motion of the actuator (136) to at least one of the shutter (360) and the component feeding-pressure control valve (338) of the bulk feeder (90), of the mechanical synchronization device includes a final nozzle lowering allowance device that allows the actuator (136) to lower the suction nozzle (96) to a lowering end position by allowing the continuation of an operation of the nozzle lifting and lowering device (128) even after at least one of the shutter (360) and the component feeding-pressure control valve (338) reaches a movement limit and is not able to move any more.

3. The electronic circuit component mounting device according to claim 1 or 2,
wherein the mechanical synchronization device includes
a nozzle/shutter synchronizing portion that mechanically synchronizes the movement of the shutter (360) to the opening position with the lowering motion of the suction nozzle (96), and
a shutter/component feeding-pressure control valve synchronizing portion that mechanically synchronizes the blocking of the component feeding-gas pressure, which is performed by the component feeding-pressure control valve (338), with the movement of the shutter (360) to the opening position.

4. The electronic circuit component mounting device according to claim 3,
wherein a movable portion of the component feeding-pressure control valve (338) is fixed to the shutter (360), so that the blocking of the component feeding-gas pressure performed by the component feeding-pressure control valve (338) is mechanically synchronized with the movement of the shutter (360) to the opening position.

5. The electronic circuit component mounting device according to any one of claims 1 to 4,
wherein the mechanical synchronization device includes a nozzle/suction-negative pressure control valve synchronizing portion that mechanically synchronizes the lowering motion of the suction nozzle (96) with the start of supplying of the component suction-negative pressure to the suction nozzle (96) by transmitting the motion of the actuator (136) to the suction-negative pressure control valve (110).

6. The electronic circuit component mounting device according to claim 5,
wherein the nozzle/suction-negative pressure control valve synchronizing portion includes a first lifting and lowering member (132) that is lifted and lowered by the actuator (136), a second lifting and lowering member (470) that is provided so as to be lifted and lowered relative to the first lifting and lowering member (132),
a biasing device (472) that is provided between the first lifting and lowering member (132) and the second lifting and lowering member (470) and biases the first lifting and lowering member (132) and the second lifting and lowering member (470) in a direction away from each other,
a separation limit defining device (474) that defines a limit of separation of the second lifting and lowering member (470) from the first lifting and lowering member (132) caused by the biasing device (472), and
a lowering limit defining device (490) that defines a lowering limit of the second lifting and lowering member (470) caused by the lowering of the first lifting and lowering member (132), and
the suction nozzle (96) is lowered by the lowering of the first lifting and lowering member (132) and the suction-negative pressure control valve (110) is operated by the lowering of the second lifting and lowering member (470), so that the first lifting and lowering member (132) is lowered to continue the lowering of the suction nozzle (96) even after the lowering of the second lifting and lowering member (470) is stopped by the lowering limit defining device (490).

7. The electronic circuit component mounting device according to any one of claims 1 to 6,
wherein the bulk feeder (90) includes plural kinds of bulk feeders (90) each of which supplies one kind of electronic circuit components (222) among plural kinds of electronic circuit components (222) having different heights, and
these plural kinds of bulk feeders (90) are adapted so that height positions of upper surfaces of the electronic circuit components (222) guided to the component supply section (250) by the guide passage (248) are equal to each other.

## Patentansprüche

1. Vorrichtung zum Montieren elektronischer Schaltungsbauteile, die umfasst:
eine Vorrichtung (22) zum Halten eines Schaltungs-Substrats, die ein Schaltungs-Substrat (44) lösbar hält;
einen Bulk-Feeder (90), der a) einen Bauteil-Aufbewahrungsabschnitt (210), in dem elektronische Schaltungsbauteile (222) lose aufbewahrt werden, und b) einen Bauteil-Transportabschnitt (212) enthält, der die elektronischen Schaltungsbauteile (222), die in dem Bauteil-Aufbewahrungsabschnitt (210) aufbewahrt werden, in einem Führungskanal (248) in einer Reihe ausrichtet und die elektronischen Schaltungsbauteile (222) zu einem Bauteil-Zuführ-Teilabschnitt (250) transportiert;
eine Montage-Vorrichtung (92), die a) eine Ansaugdüse (96), die das elektronische Schaltungsbauteil (222) mittels Unterdruck ansaugt und hält, b) ein Ventil (110) zur Steuerung von Ansaug-Unterdruck, das die Zufuhr von Unterdruck zum Ansaugen von Bauteilen zu der Ansaugdüse (96) steuert, sowie c) eine Vorrichtung (128, 130) zum Anheben und Absenken der Düse enthält, die die Ansaugdüse anhebt und absenkt, und die die elektronischen Schaltungsbauteile (222) aus dem Bauteil-Zuführ-Teilabschnitt (250) des Bulk-Feeders (90) mit der Ansaugdüse (96) nacheinander entnimmt und das elektronische Schaltungsbauteil (222) auf dem von der Vorrichtung (22) zum Halten eines Schaltungs-Substrats gehaltenen Schaltung-Substrat (44) montiert;
einen Kopf-Körper (88), der relativ zu der Vorrichtung (22) zum Halten eines Schaltungs-Substrats bewegt werden kann und zusammen mit dem Bulk-Feeder (90) und der Montage-Vorrichtung (92) einen Montage-Kopf (26) bildet;
eine Vorrichtung (28) zum Bewegen des Kopfes, die den Montage-Kopf (26) relativ zu der Vorrichtung (22) zum Halten eines Schaltungs-Substrats bewegt, indem sie den Kopf-Körper (88) bewegt;
**gekennzeichnet durch**
ein Betätigungselement (136); und
eine Vorrichtung für mechanische Synchronisation, die A) das Absenken der Ansaugdüse (96) mit B) a) wenigstens einem Teil von Vorgängen zum Zuführen der Bauteile (222) durch den Bulk-Feeder (90) oder/und b) dem Beginn der Zufuhr von Unterdruck zum Ansaugen von Bauteilen, die durch das Ventil (110) zur Steuerung von Ansaug-Unterdruck durchgeführt wird, mechanisch synchronisiert, indem sie die Bewegung des Betätigungselementes (136) auf die Vorrichtung (128) zum Anheben und Absenken der Düse und den Bulk-Feeder (90) oder/und das Ventil (110) zur Steuerung von Ansaug-Unterdruck mechanisch überträgt,
wobei die Vorrichtung für mechanische Synchronisation die Bewegung des Betätigungselementes (136) auf 1) einen Verschluss (360), der an eine Verschluss-Position, an der der Bauteil-Zuführ-Teilabschnitt (250) geschlossen ist, und eine Öffnungs-Position bewegt werden kann, an der der Bauteil-Zuführ-Teilabschnitt (250) geöffnet ist, oder/und 2) ein Ventil (338) zur Steuerung von Bauteiltransport-Druck des Bulk-Feeders (90) mechanisch überträgt, das Bauteiltransport-Gasdruck steuert, der dem Führungskanal (248) zugeführt wird, und so eine Absenk-Bewegung der Ansaugdüse (96) mit der Bewegung des Verschlusses (360) an die Öffnungs-Position oder/und dem Sperren des Bauteiltransport-Gasdrucks, dass durch das Ventil (338) zur Steuerung von Bauteiltransport-Druck durchgeführt wird, mechanisch synchronisiert.

2. Vorrichtung zum Montieren elektronischer Schaltungsbauteile nach Anspruch 1,
wobei ein Abschnitt der Vorrichtung für mechanische Synchronisation, der die Bewegung des Betätigungselementes (136) auf den Verschluss (360) oder/und das Ventil (338) zur Steuerung von Bauteiltransport-Druck des Bulk-Feeders (90) überträgt, eine Vorrichtung zum Zulassen von abschließendem Absenken der Düse enthält, die zulässt, dass das Betätigungselement (136) die Ansaugdüse (96) an eine Absenk-Endposition absenkt, indem sie die Fortsetzung einer Funktion der Vorrichtung (128) zum Anheben und Absenken der Düse selbst dann zulässt, nachdem der Verschluss (360) oder/und das Ventil (338) zur Steuerung von Bauteiltransport-Druck eine Bewegungsgrenze erreicht/erreichen und sich nicht mehr bewegen kann/können.

3. Vorrichtung zum Montieren elektronischer Schaltungsbauteile nach Anspruch 1 oder 2,
wobei die Vorrichtung für mechanische Synchronisation enthält:
einen Abschnitt zum Synchronisieren von Düse/Verschluss, der die Bewegung des Verschlusses (360) an die Öffnungs-Position mit der Absenk-Bewegung der Ansaugdüse (96) mechanisch synchronisiert, und
einen Abschnitt zum Synchronisieren von Verschluss/Ventil zur Steuerung von Bauteiltransport-Druck, der das Sperren des Bauteiltransport-Gasdrucks, das durch das Ventil (338) zur Steuerung von Bauteiltransport-Druck durchgeführt wird, mit der Bewegung des Verschlusses (63) an die Öffnungs-Position mechanisch synchronisiert.

4. Vorrichtung zum Montieren elektronischer Schaltungsbauteile nach Anspruch 3,
wobei ein beweglicher Abschnitt des Ventils (338) zur Steuerung von Bauteiltransport-Druck an dem Verschluss (360) so befestigt ist, dass das Sperren des Bauteiltransport-Gasdrucks, dass durch das Ventil (338) zur Steuerung von Bauteiltransport-Druck durchgeführt wird, mit der Bewegung des Verschlusses (360) an die Öffnungs-Position mechanisch synchronisiert wird.

5. Vorrichtung zum Montieren elektronischer Schaltungsbauteile nach einem der Ansprüche 1 bis 4, wobei die Vorrichtung für mechanische Synchronisation einen Abschnitt zum Synchronisieren von Düse/Ventil zur Steuerung von Ansaug-Unterdruck enthält, der die Absenk-Bewegung der Ansaugdüse (96) mit dem Beginn der Zufuhr von Unterdruck zum Ansaugen von Bauteilen zu der Ansaugdüse (96) mechanisch synchronisiert, indem er die Bewegung des Betätigungselementes (136) auf das Ventil (110) zur Steuerung von Ansaug-Unterdruck überträgt.

6. Vorrichtung zum Montieren elektronischer Schaltungsbauteile nach Anspruch 5,
wobei der Abschnitt zum Synchronisieren von Düse/Ventil zur Steuerung von Ansaug-Unterdruck enthält:
ein erstes Anhebe-und-Absenk-Element (132), das durch das Betätigungselement (136) angehoben und abgesenkt wird,
ein zweites Anhebe-und-Absenk-Element (470), das relativ zu dem ersten Anhebe-und-Absenk-Element (132) angehoben und abgesenkt wird,
eine Spann-Vorrichtung (472), die sich zwischen dem ersten Anhebe-und-Absenk-Element (132) und dem zweiten Anhebe-und-Absenk-Element (470) befindet und das erste Anhebe-und-Absenk-Element (132) und das zweite Anhebe-und-Absenk-Element (470) in einer Richtung voneinander weg spannt,
eine Vorrichtung (474) zum Definieren einer Trennungs-Grenze, die eine Grenze der durch die Spann-Vorrichtung (472) bewirkten Trennung des zweiten Anhebe-und-Absenk-Elementes (470) von dem ersten Anhebe-und-Absenk-Element (132) definiert, und
eine Vorrichtung (490) zum Definieren einer Absenk-Grenze, die eine Grenze des durch das Absenken des ersten Anhebe-und-Absenk-Elementes (132) bewirkten Absenkens des zweiten Anhebe-und-Absenk-Elementes (470) definiert, und
die Ansaugdüse (96) durch das Absenken des ersten Anhebe-und-Absenk-Elementes (132) abgesenkt wird und das Ventil (110) zur Steuerung von Ansaug-Unterdruck durch das Absenken des zweiten Anhebe-und-Absenk-Elementes (470) betätigt wird, so dass das erste Anhebe-und-Absenk-Element (132) abgesenkt wird und das Absenken der Ansaugdüse (96) selbst dann fortsetzt, nachdem das Absenken des zweiten Anhebe-und-Absenk-Elementes (470) durch die Vorrichtung (490) zum Definieren einer Absenk-Grenze beendet wird.

7. Vorrichtung zum Montieren elektronischer Schaltungsbauteile nach einem der Ansprüche 1 bis 6,
wobei der Bulk-Feeder (90) mehrere Typen von Bulk-Feedern (90) einschließt, von denen jeder einen Typ elektronischer Schaltungsbauteile (222) von den mehreren Typen elektronischer Schaltungsbauteile (222) mit unterschiedlicher Höhe zuführt, und
diese mehreren Typen von Bulk-Feedern (90) so eingerichtet sind, dass HöhenPositionen oberer Flächen der durch den Führungskanal (248) zu dem Bauteil-Zuführ-Teilabschnitt (250) geführten elektronischen Schaltungsbauteile (222) einander gleich sind.

## Revendications

1. Dispositif de montage de composants de circuit électronique, comprenant :
un dispositif de maintien de substrat de circuit (22) qui maintient de manière amovible un substrat de circuit (44) ;
un dispositif d'alimentation en vrac (90) qui comprend (a) une partie d'emmagasinage de composants (210) permettant d'emmagasiner des composants de circuit électronique (222) en vrac et (b) une partie d'alimentation de composants (212) permettant d'aligner les composants de circuit électronique (222), qui sont emmagasinés dans la partie d'emmagasinage de composants (210), dans un passage formant guide (248), formant une ligne, et d'alimenter les composants de circuit électronique (222) vers une section de fourniture de composants (250) ;
un dispositif de montage (92) qui comprend (a) une buse d'aspiration (96) permettant d'aspirer et de maintenir le composant de circuit électronique (222) par pression négative, (b) une vanne de commande de pression négative d'aspiration (110) permettant de commander l'alimentation de pression négative d'aspiration de composant fournie à la buse d'aspiration (96), et (c) un dispositif d'élévation et d'abaissement de buse (128, 130) permettant d'élever et d'abaisser la buse d'aspiration, et qui sort les composants de circuit électronique (222) de la section de fourniture de composants (250) du dispositif d'alimentation en vrac (90) un par un au moyen de la buse d'aspiration (96) et monte le composant de circuit électronique (222) sur le substrat de circuit (44) maintenu par le dispositif de maintien de substrat de circuit (22) ;
un corps de tête (88) qui est conçu de manière à être mobile par rapport au dispositif de maintien de substrat de circuit (22) et forme une tête de montage (26) avec le dispositif d'alimentation en vrac (90) et le dispositif de montage (92) ;
un dispositif de déplacement de tête (28) qui déplace la tête de montage (26) par rapport au dispositif de maintien de substrat de circuit (22) en déplaçant le corps de tête (88) ;
**caractérisé par**
un actionneur (136) ; et
un dispositif de synchronisation mécanique qui synchronise mécaniquement (A) l'abaissement de la buse d'aspiration (96) avec (B) au moins (a) au moins une partie des opérations d'alimentation des composants (222) par le dispositif d'alimentation en vrac (90) et/ou (b) le début de la fourniture de pression négative d'aspiration de composant, qui est réalisée par la vanne de commande de pression négative d'aspiration (110), en transmettant mécaniquement le mouvement de l'actionneur (136) au dispositif d'élévation et d'abaissement de buse (128), et à au moins le dispositif d'alimentation en vrac (90) et/ou la vanne de commande de pression négative d'aspiration (110),
dans lequel le dispositif de synchronisation mécanique transmet mécaniquement le mouvement de l'actionneur (136) à au moins (i) un obturateur (360) qui est déplaçable vers une position de fermeture dans laquelle la section de fourniture de composants (250) est fermée et vers une position d'ouverture dans laquelle la section de fourniture de composants (250) est ouverte et/ou (ii) une vanne de commande de pression d'alimentation de composants (338) qui commande une pression de gaz d'alimentation de composants destinée à être fournie au passage formant guide (240) du dispositif d'alimentation en vrac (90), synchronisant ainsi de manière mécanique un mouvement d'abaissement de la buse d'aspiration (96) avec au moins le déplacement de l'obturateur (360) vers la position de d'ouverture et/ou le blocage de la pression de gaz d'alimentation de composants qui est réalisé par la vanne de commande de pression d'alimentation de composants (338).

2. Dispositif de montage de composants de circuit électronique selon la revendication 1,
dans lequel une partie du dispositif de synchronisation mécanique, laquelle partie transmet le mouvement de l'actionneur (136) à au moins l'obturateur (360) et/ou la vanne de commande de pression d'alimentation de composants (338) du dispositif d'alimentation en vrac (90), comprend un dispositif d'autorisation d'abaissement de buse final qui autorise l'actionneur (136) à abaisser la buse d'aspiration (96) vers une position finale d'abaissement en permettant la poursuite du fonctionnement du dispositif d'élévation et d'abaissement de buse (128) même après que l'obturateur (360) et/ou la vanne de commande de pression d'alimentation de composants (338) ait atteint une limite de mouvement et ne puisse plus se déplacer.

3. Dispositif de montage de composants de circuit électronique selon la revendication 1 ou 2,
dans lequel le dispositif de synchronisation mécanique comprend
une partie de synchronisation de buse et d'obturateur qui synchronise mécaniquement le déplacement de l'obturateur (360) vers la position d'ouverture avec le mouvement d'abaissement de la buse d'aspiration (96), et
une partie de synchronisation d'obturateur et de de vanne de commande de pression d'alimentation de composants qui synchronise mécaniquement le blocage de la pression de gaz d'alimentation de composants, qui est réalisé par la vanne de commande de pression d'alimentation de composants (338), avec le déplacement de l'obturateur (360) vers la position d'ouverture.

4. Dispositif de montage de composants de circuit électronique selon la revendication 3,
dans lequel une partie mobile de la vanne de commande de pression d'alimentation de composants (338) est fixée sur l'obturateur (360) de façon que le blocage de la pression de gaz alimentation de composants réalisé par la vanne de commande de pression d'alimentation de composants (338) soit synchronisé mécaniquement avec le déplacement de l'obturateur (360) vers la position d'ouverture.

5. Dispositif de montage de composants de circuit électronique selon l'une quelconque des revendications 1 à 4,
dans lequel le dispositif de synchronisation mécanique comprend une partie de synchronisation de buse et de vanne de commande de pression négative d'aspiration qui synchronise mécaniquement le mouvement d'abaissement de la buse d'aspiration (96) avec le début de la fourniture de la pression négative d'aspiration de composant à la buse d'aspiration (96) en transmettant le mouvement de l'actionneur (136) à la vanne de commande de pression négative d'aspiration (110).

6. Dispositif de montage de composants de circuit électronique selon la revendication 5,
dans lequel la partie de synchronisation de buse et de vanne de commande de pression négative d'aspiration comprend
un premier élément d'élévation et d'abaissement (132) qui est levé et abaissé par l'actionneur (136),
un second élément d'élévation et d'abaissement (470) qui est conçu de manière à pouvoir être levé et abaissé par rapport au premier élément d'élévation et d'abaissement (132),
un dispositif de contrainte (472) qui est situé entre le premier élément d'élévation et d'abaissement (132) et le second élément d'élévation et d'abaissement (470) et contraint le premier élément d'élévation et d'abaissement (132) et le second élément d'élévation et d'abaissement (470) dans une direction les éloignant l'un de l'autre,
un dispositif de définition de limite de séparation (474) qui définit une limite de séparation du second élément d'élévation et d'abaissement (470) par rapport au premier élément d'élévation et d'abaissement (132) causée par le dispositif de contrainte (472), et
un dispositif de définition de limite d'abaissement (490) qui définit une limite d'abaissement du second élément d'élévation et d'abaissement (470) causé par l'abaissement du premier élément d'élévation et d'abaissement (132), et
la buse d'aspiration (96) est abaissée par l'abaissement du premier élément d'élévation et d'abaissement (132) et la vanne de commande de pression négative d'aspiration (110) est actionnée par l'abaissement du second élément d'élévation et d'abaissement (470), de sorte que le premier élément d'élévation et d'abaissement (132) est abaissé pour poursuivre l'abaissement de la buse d'aspiration (96) même après que l'abaissement du second élément d'élévation et d'abaissement (410) ait été stoppé par le dispositif de définition de limite d'abaissement (490).

7. Dispositif de montage de composants de circuit électronique selon l'une quelconque des revendications 1 à 6,
dans lequel le dispositif d'alimentation en vrac (90) comprend plusieurs types de dispositifs d'alimentation en vrac (90) dont chacun fournit une sorte de composants de circuit électronique (222) parmi plusieurs sortes de composants de circuit électronique (222) ayant différentes hauteurs, et
ces plusieurs types de dispositifs d'alimentation en vrac (90) sont conçus de façon que les positions en hauteur de surfaces supérieures des composants de circuit électronique (222) guidés vers la section de fourniture de composants (250) par le passage formant guide (248) soient égales les unes aux autres.
